# EUROPEAN PATENT SPECIFICATION

(11) **EP 1 413 182 B1**
(45) Date of publication and mention of the grant of the patent: **21.03.2007**
(21) Application number: 02738549.1
(22) Date of filing: 24.06.2002
(51) Int. Cl.: H05K 13/00

(54) **DEVICE FOR SUPPORTING FLAT PRODUCTS**
VORRICHTUNG ZUM UNTERSTÜTZEN VON PLATTENPRODUKTEN
DISPOSITIF DE SUPPORT POUR PRODUITS PLATS

(30) Priority: 19.07.2001 EP 01202768
(43) Date of publication of application: 28.04.2004
(73) Proprietor: Assembléon N.V., 5503 LA Veldhoven (NL)
(72) Inventor: VAN DEURSEN, Johannes A. M., Int. Octrooibureau BV, NL-5656 AA Eindhoven (NL)
(74) Representative: Veldman-Dijkers, Cornelia G. C.
(86) International application number: PCT/IB2002/002539
(87) International publication number: WO 2003/009664

(56) References cited:
- DE-U- 29 718 477
- US-A- 5 218 753
- US-A- 5 794 329

## Description

The invention relates to a device for supporting flat products, especially printed circuit boards, provided with a supporting member as well as supporting pins, which can be placed on and removed from the supporting member, wherein recesses and protrusions fitting in these recesses are provided for positioning the supporting pins in relation to the supporting member.

Such devices are known, for example, from US patents 5.218.753 and 5.794.329. In these known devices the protrusions are provided at the ends of the supporting pins such that the centrelines of the protrusions are in line with the centrelines of the supporting pins. The end of a protrusion can be inserted at choice in one of the recesses provided in the supporting member, the shape of these recesses being complementary to that of the protrusion. A supporting pin projecting above the supporting member is always in line with the centreline of the hole provided in the supporting member.

According to the invention, the recesses and the protrusions now have a non-circular cross-section, while a combination of a recess and a protrusion positioning a supporting pin in a particular position on the supporting member is located eccentrically in relation to the centreline of the relevant supporting pin.

The use of the eccentric location in relation to the centreline of a supporting pin of the combination of recess and protrusion positioning the supporting pin in a particular position in relation to the supporting member, renders it possible to place the supporting pin in different positions in relation to the centreline of this combination of recess and protrusion, whereby in the set position a rotation of the supporting pin about the centreline of the combination of recess and protrusion is prevented by the non-circular cross-section of the recess and the protrusion.

Preferably, the protrusions are rigidly attached to the supporting pin, and the recesses are provided in the supporting member, but it will alternatively be conceivable to provide the supporting member with protrusions, while the recesses are provided, for example, in a base or the like which is connected to the supporting pin.

The invention will be explained in more detail below with reference to the appended Figures.
Fig. 1 is a diagrammatic perspective view of a supporting pin, the lower end of which is attached to a base.
Fig. 2 is a partial side elevation, on a larger scale, of the supporting pin with base shown in Fig. 1.
Fig. 3 is a diagrammatic plan view of two supporting members arranged next to each other with supporting pins placed thereon.

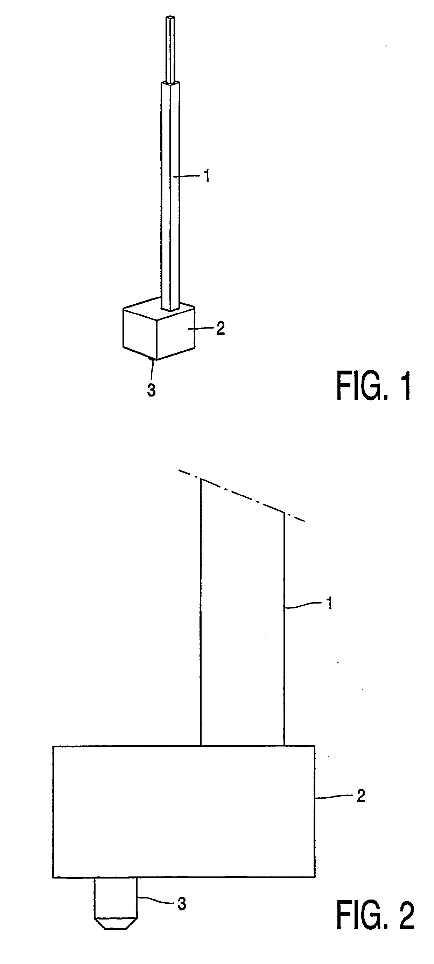

Fig. 1 shows a supporting pin 1, the lower end of which is attached to a base 2. A protrusion 3, which has a non-circular cross-section, square in the embodiment shown, is provided at the bottom of the base

A desired number of such supporting pins can be placed on a supporting member 4, often in the shape of a supporting plate, in which regularly spaced recesses 5 are provided in rows and columns.

As is also explained in cited publications, such supporting pins for supporting flat objects, in general printed circuit boards, are placed in a pattern on the supporting member 4 such that they only support the flat object concerned in certain intended locations at the bottom, in the case of printed circuit boards in those locations that do not contain circuit components.

Subsequently, the circuit boards thus supported are subjected to a desired operation, for example by feeding the circuit board thus supported through a machine intended for further operations.

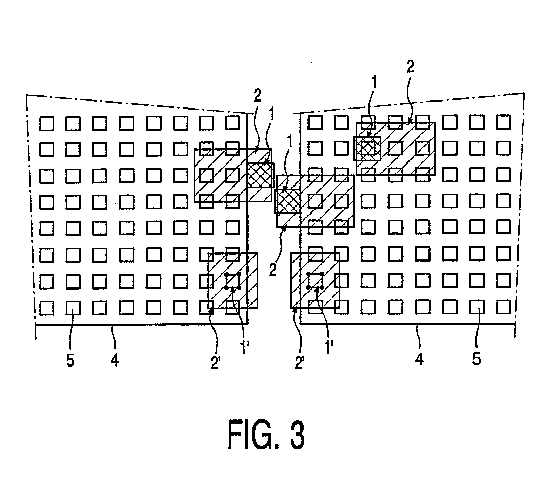

As was explained above, the protrusions positioning the supporting pins in relation to the supporting member are located in line with the supporting pins in the known constructions. The consequence of this for the known supporting pins 1' supported by bases 2' is that a supporting pin 1' is always located in line with the centreline of the recess 5 containing a protrusion connected to the supporting pin 1', as is shown diagrammatically in Fig. 3.

As is also shown diagrammatically in Fig. 3, however, a positioning pin 1 placed on a base 2 can be arranged in different positions in relation to the centreline of the recess 5 in a supporting member 4 in which the protrusion 3 belonging to said supporting pin 1 has been inserted. It will be clear that, given a certain number of recesses 5 in a supporting member 4, the number of setting possibilities of supporting pins placed on a supporting member 4 has thus been considerably increased compared to the prior art.

Although it was indicated above that the protrusion 3 has a square cross-section and the recess 5 has a cross-section complementary to the former, it will be clear that also other non-circular cross-sections may be chosen for the protrusion 3 and the recess 5, for example rectangular, hexagonal, elliptical or the like, as long as it is ensured that the protrusion 3 can be inserted in at least two different orientations in a recess 5.

As was also stated above, it is alternatively possible to provide a recess in the base 2 such that this recess is located eccentrically in relation to the centreline of the supporting pin 1, while the supporting member 4 instead of having recesses 5 is provided with protrusions, which are complementary to the recess provided in base 2.

The base 2 should preferably be equipped with a magnet located near the bottom of the base, while the supporting member 4, at least at the top, is made of a magnetizable material. In this way, a strong bond between the base 2, carrying the supporting pin 1, and the supporting member 4 can be realized.

## Claims

1. A device for supporting flat products, especially printed circuit boards, provided with a supporting member (4) as well as supporting pins (1), which can be placed on and removed from the supporting member (4), wherein recesses (5) and protrusions (3) fitting in these recesses (5) are provided for positioning the supporting pins (1) in relation to the supporting member (4), **characterized in that** the recesses (5) and the protrusions (3) have a non-circular cross-section, while a combination of a recess (5) and a protrusion (3) positioning a supporting pin (1) in a particular position on the supporting member (4) is located eccentrically in relation to the centreline of the relevant supporting pin (1).

2. A device as claimed in claim 1, **characterized in that** the supporting pin (1) is attached to a base (2) which is provided with a protrusion (3) on the side facing away from the supporting pin (1), while the supporting member (4) is provided with a number of recesses (5).

3. A device as claimed in claim 1 or 2, **characterized in that** the protrusion (3) has a polygonal cross-section.

4. A device as claimed in claim 1 or 2, **characterized in that** a magnet is connected to the lower end of the supporting pin (1), while at least the upper side of the supporting member (4) is made of a magnetizable material.

5. A supporting pin (1) designed in particular for a device as claimed in any one of the preceding claims, wherein a protrusion (3) of non-circular cross-section, located eccentrically in relation to the centreline of the supporting pin (1), is connected to the lower end of the supporting pin (1).

## Patentansprüche

1. Vorrichtung zum Tragen von flachen Produkten, insbesondere Leiterplatten, mit einem Tragteil (4) sowie Tragstiften (1), die auf dem Tragteil (4) platziert und von demselben entfernt werden können, wobei Ausnehmungen (5) und Vorsprünge (3), die in diese Ausnehmungen (5) passen, vorgesehen sind zum Positionieren der Tragstifte (1) in Relation zu dem Tragteil (4), **dadurch gekennzeichnet, dass** die Ausnehmungen (5) und Vorsprünge (3) einen nichtkreisförmigen Querschnitt haben, wobei eine Kombination aus einer Ausnehmung (5) und einem Vorsprung (3), die einen Tragstift (1) in einer besonderen Position auf dem Tragteil (4) positioniert, in Relation zu der Mittellinie des betreffenden Tragstiftes (1) exzentrisch angeordnet ist.

2. Vorrichtung nach Anspruch 1, **dadurch gekennzeichnet, dass** der Tragstift (1) auf einem Unterteil (2) befestigt ist, das mit einem Vorsprung (3) auf der von dem Tragstift (1) abgewandten Seite versehen ist, wohingegen das Tragteil (4) mit einer Anzahl von Ausnehmungen (5) versehen ist.

3. Vorrichtung nach Anspruch 1 oder 2, **dadurch gekennzeichnet, dass** der Vorsprung (3) einen polygonalen Querschnitt hat.

4. Vorrichtung nach Anspruch 1 oder 2, **dadurch gekennzeichnet, das** ein Magnet mit dem unteren Ende des Tragstiftes (1) verbunden ist, wohingegen wenigstens die obere Seite des Tragteils (4) aus einem magnetisierbaren Material hergestellt ist.

5. Tragstift (1), ausgebildet insbesondere für eine Vorrichtung nach einem der vorhergehenden Ansprüche, wobei ein Vorsprung (3) mit nichtkreisförmigem Querschnitt, der in Relation zu der Mittellinie des Tragstiftes (1) exzentrisch angeordnet ist, mit dem unteren Ende des Tragstiftes (1) verbunden ist.

## Revendications

1. Dispositif pour supporter des produits plats, en particulier des plaquettes de circuits imprimés, équipé d'un élément de support (4) ainsi que de broches de support (1) qui peuvent être placées sur et enlevées de l'élément de support (4), dans lequel il est prévu des évidements (5) et des saillies (3) s'ajustant dans ces évidements (5) pour positionner les broches de support (1) par rapport à l'élément de support (4), **caractérisé en ce que** les évidements (5) et les saillies (3) ont une section transversale non circulaire, tandis qu'une combinaison d'un évidement (5) et d'une saillie (3) ajustant une broche de support (1) dans une position particulière sur l'élément de support (4) est située excentriquement par rapport à l'axe géométrique de ladite broche de support appropriée (1).

2. Dispositif selon la revendication 1, **caractérisé en ce que** la broche de support (1) est fixée sur une base (2) qui est dotée d'une saillie (3) sur le côté détourné de la broche de support (1), tandis que l'élément de support (4) est muni d'un certain nombre d'évidements (5).

3. Dispositif selon la revendication 1 ou 2, **caractérisé en ce que** la saillie (3) présente une section transversale polygonale.

4. Dispositif selon la revendication 1 ou 2, **caractérisé en ce qu'**un aimant est connecté à l'extrémité inférieure de la broche de support (1), tandis qu'au moins le côté supérieur de l'élément de support (4) est réalisé en matériau magnétisable.

5. Broche de support (1) conçue en particulier pour un dispositif selon l'une quelconque des revendications précédentes, dans laquelle une saillie (3) de section transversale non circulaire, située excentriquement par rapport à l'axe géométrique de la broche de support (1) est raccordée à l'extrémité inférieure de la broche de support (1).
